# FASCICULE DE BREVET EUROPEEN

(11) **EP 0 690 573 B1**
(45) Date de publication et mention de la délivrance du brevet: **31.03.1999**
(21) Numéro de dépôt: 95410059.0
(22) Date de dépôt: 21.06.1995
(51) Int. Cl.: H03K 17/687, G05F 3/26, H03K 17/041

(54) **Circuit de commande de mise en veille partielle d'une source de polarisation**
Steuerschaltung für den teilweisen Standby-Betrieb einer Vorspannungsquelle
Control circuit for putting a bias source into partial stand by

(30) Priorité: 27.06.1994 FR 9408120
(43) Date de publication de la demande: 03.01.1996
(73) Titulaire: STMicroelectronics S.A., 94250 Gentilly (FR)
(72) Inventeur: Sirito-Olivier, Philippe, F-38100 Grenoble (FR); Majoux, Bernard, F-38240 Meylan (FR)
(74) Mandataire: de Beaumont, Michel

(56) Documents cités:
- EP-A- 0 043 257
- EP-A- 0 396 996
- IEEE JOURNAL OF SOLID-STATE CIRCUITS, vol. SC-21, no. 6, Décembre 1986 NEW YORK US, pages 901-908, FISHER ET AL. 'A 50-Mbit/s CMOS optical transmitter integrated circuit'

## Description

La présente invention concerne un circuit de commande de mise en veille d'une source de polarisation de type en ΔVbe/R à partir d'un signal de commande de mise en veille.

Les circuits de mise en veille sont utilisés pour réduire l'énergie consommée d'un circuit pendant des périodes de non-utilisation en désactivant la source de polarisation, sans pour autant qu'il soit nécessaire de mettre le circuit hors service. Ils trouvent un intérêt tout particulier dans des systèmes à alimentation autonome, par exemple constituée de batteries rechargeables ou de piles, tels des capteurs à distance. De tels capteurs ont par exemple pour rôle de transmettre des informations à une centrale en cas de changement de l'état du capteur. Dans de tels systèmes, il est essentiel de limiter la consommation du capteur pendant les périodes où son état est stable. Pour ce faire, on met en veille la source de polarisation de ses organes d'émission lorsque le capteur est dans un état stable durant un intervalle de temps prédéterminé. Ceci permet de réduire la consommation du capteur pendant ces périodes. La source de polarisation est réactivée, dès que le signal de commande de mise en veille change d'état, indiquant que le capteur ne se trouve plus dans un état stable.

Un inconvénient des circuits classiques de mise en veille réside dans leur consommation d'énergie pendant leur commutation et pendant les périodes de veille de la source de polarisation. De fait, on a généralement recours, pour commander la mise en veille, à un dispositif logique à base d'inverseurs. Le rôle de ce dispositif est de transformer le signal de commande de mise en veille en un signal logique du point de vue de la source de polarisation. La consommation en courant de l'inverseur présente, au moment de la commutation, un pic qui s'amortit dans les résistances série des transistors MOS qui constituent cet inverseur. Cette consommation d'énergie est donc fonction du temps de commutation du signal de commande de mise en veille.

De plus, bien que le signal de mise en veille soit généralement déjà un signal logique, il est fréquent que les potentiels de ses états ne correspondent pas aux potentiels d'alimentation de la source de polarisation. Il en découle une consommation d'énergie résiduelle permanente, pendant les périodes de veille de la source de polarisation. Cette consommation est d'autant plus importante que la différence entre le potentiel de l'état bas du signal de commande de mise en veille et le potentiel de la borne négative d'alimentation de la source de polarisation est importante.

En outre, dans certains cas, on a besoin de maintenir certains modules du circuit activés par la source de polarisation, alors même que d'autres modules pourraient être mis en veille.

La solution actuelle à ce genre de situation est de prévoir une source de polarisation distincte pour chaque module, ou ensemble de modules, du circuit pouvant être mis en veille en même temps. Ainsi, on est contraint d'augmenter le nombre de sources de polarisation si l'on souhaite réduire la consommation d'énergie du circuit, ce qui accroît la surface de la puce nécessaire pour réaliser le circuit sous forme de circuit intégré.

Le document EP-A-0 396 996 décrit un circuit de fourniture d'une tension de référence compensée en température utilisant une source de polarisation en ΔVbe/R, comportant deux transistors bipolaires montés en miroir, et un moyen de mise en veille de cette source de polarisation à partir d'un signal de commande de mise en veille.

La présente invention a pour objet de remédier à ces inconvénients en proposant un circuit de commande de mise en veille d'une source de polarisation à faible énergie consommée pendant et hors des périodes de commutation de la source de polarisation.

Un autre objet de la présente invention est de proposer un circuit de commande d'une source de polarisation, qui autorise une mise en veille partielle de la source de polarisation suivant différents modes de fonctionnement.

Pour atteindre ces objets, la présente invention prévoit un circuit de commande de mise en veille partielle d'une source de polarisation en ΔVbe/R à partir d'au moins un signal de commande de mise en veille, comportant au moins un dispositif de mise en veille partielle muni de moyens pour modifier virtuellement, en fonction de l'état du signal de commande de mise en veille, la surface d'émetteur d'au moins un des transistors bipolaires, montés en miroirs, que comporte la source de polarisation, et au moins un dispositif logique recevant le signal de commande de mise en veille et constitué d'au moins un premier inverseur à charge active commandée par la source de polarisation, une sortie dudit dispositif logique étant destinée à commander lesdits moyens d'augmentation virtuelle de la surface du transistor bipolaire de la source de polarisation.

Selon un mode de réalisation de la présente invention, le circuit de commande de mise en veille partielle comporte au moins un interrupteur de commande d'au moins un étage de sortie de la source de polarisation, ledit interrupteur étant commandé par la sortie du dispositif logique.

Selon un mode de réalisation de la présente invention, lesdits moyens pour modifier virtuellement la surface d'émetteur d'un des transistors bipolaires de la source de polarisation sont constitués d'au moins un transistor bipolaire monté, par l'intermédiaire d'un transistor MOS à canal N commandé par la sortie dudit dispositif logique, en parallèle avec ledit transistor bipolaire d'une branche de la source de polarisation dont il doit modifier virtuellement la surface d'émetteur.

Selon un mode de réalisation de la présente invention, la valeur du courant de veille circulant dans la source de polarisation est paramétrée par le rapport des surfaces d'émetteur entre les deux transistors bipolaires montés en parallèle et le transistor d'une autre branche de la source de polarisation.

Selon un mode de réalisation de la présente invention, ladite charge active dudit dispositif logique est constituée d'un transistor MOS à canal N monté en miroir avec des transistors MOS inférieurs à canal N de la source de polarisation, ledit premier inverseur comportant au moins un transistor MOS à canal P qui reçoit, sur sa grille, le signal de commande de mise en veille, son drain étant relié au drain du transistor à canal N constituant la charge active et sa source étant connectée à une borne positive d'alimentation.

Selon un mode de réalisation de la présente invention, au moins un transistor MOS à canal P, monté en diode, est intercalé entre la borne positive d'alimentation et la source du transistor MOS à canal P qui reçoit, sur sa grille, le signal de commande de mise en veille.

Selon un mode de réalisation de la présente invention, le circuit de commande de mise en veille partielle comporte en outre un dispositif d'aide au démarrage dont une sortie est reliée à une entrée de commande de la source de polarisation.

Selon un mode de réalisation de la présente invention, le dispositif d'aide au démarrage comporte un interrupteur commandé par la source de polarisation pour désactiver le dispositif d'aide au démarrage, hors des périodes de mise sous tension du circuit.

Le recours à un transistor bipolaire, propre à être connecté en parallèle avec l'un des transistors bipolaires de la source de polarisation, permet de limiter le courant qui circule dans la source de polarisation à une valeur prédéterminée. De plus, cela autorise, lors de la fabrication du dispositif de mise en veille, un paramétrage de ce dernier en fonction des applications auxquelles il est destiné. En outre, ce dispositif est indépendant de la source de polarisation. De ce fait, on pourra de même réaliser une source de polarisation disposant de plusieurs valeurs de courants de veille, correspondant chacun à une mise en veille de certains modules activés par la source de polarisation.

Le fait d'utiliser un dispositif logique du signal de commande de mise en veille, pourvu d'un inverseur à charge active commandée par la source de polarisation elle-même, permet de rendre la consommation en courant de cet inverseur indépendante, à la fois de la durée de commutation du signal de commande de mise en veille et de ses potentiels d'états.

La parité du nombre d'inverseurs que comporte le dispositif logique dépend de la signification des états du signal de commande de mise en veille du point de vue du mode de fonctionnement, actif ou en veille, de la source de polarisation.

Le recours à une déconnexion des étages de sortie de la source de polarisation, commandée par le dispositif logique, permet, notamment dans le cas où l'on souhaite disposer de plusieurs veilles partielles en fonction de différents modes de fonctionnement, de sélectionner les modules qui doivent rester polarisés pendant une veille partielle de la source de polarisation.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 représente un mode de réalisation d'un dispositif de mise en veille partielle d'une source de polarisation selon l'invention ;
la figure 2 représente la valeur du courant produit par la source de polarisation en fonction du paramétrage du dispositif de mise en veille représenté à la figure 1 ;
la figure 3 représente un mode de réalisation d'un circuit de commande de mise en veille d'une source de polarisation, à base d'un dispositif de mise en veille partielle tel que représenté à la figure 1 ; et
la figure 4 représente, sous forme de chronogrammes, les tensions et courants les plus significatifs du circuit de commande représenté à la figure 3, pendant une commutation du dispositif de mise en veille.

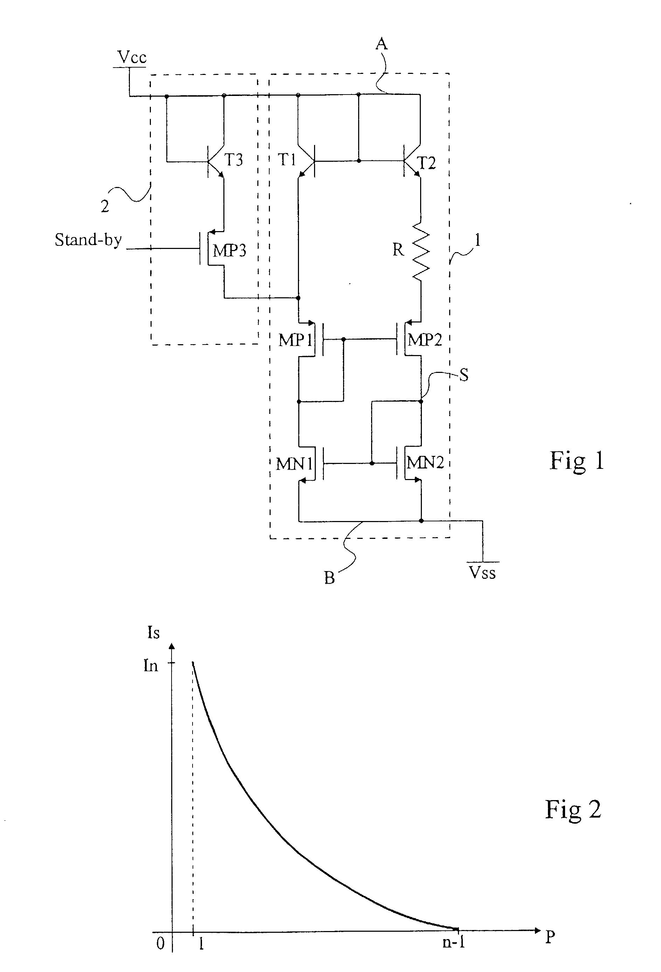

Comme le montre la figure 1, une source de polarisation 1 en ΔVbe/R est, par exemple, constituée de transistors montés en miroirs de courant et d'une résistance de polarisation R. Deux transistors bipolaires de type NPN T1, T2 ont leurs collecteurs et leurs bases connectés à une borne positive A, au potentiel Vcc, d'une tension d'alimentation. L'émetteur du transistor T1 est relié à la source d'un transistor MOS à canal P MP1. L'émetteur du transistor T2 est relié, par l'intermédiaire de la résistance de polarisation R, à la source d'un transistor MOS à canal P MP2. Ces deux transistors MOS supérieurs MP1, MP2 sont montés en miroirs et ont leurs grilles reliées au drain du transistor MP1. Le drain de chacun des transistors MP1, MP2 est respectivement relié au drain d'un transistor MOS à canal N MN1, MN2, dont la source est connectée à une borne négative B, au potentiel Vss, de la tension d'alimentation.

Les grilles de ces transistors MOS inférieurs MN1, MN2, qui sont également montés en miroir, sont reliées ensembles au drain du transistor MN2 qui constitue une borne de sortie S de la source de polarisation 1. Le rôle d'une telle source de polarisation 1 est d'activer la polarisation d'un ou plusieurs modules d'un circuit dans lequel elle est implantée, par la reproduction du courant qui la traverse sur une source de courant du module. Cette source de courant est par exemple constituée d'un transistor MOS monté en miroir sur les transistors inférieurs MN1, MN2 de la source de polarisation 1.

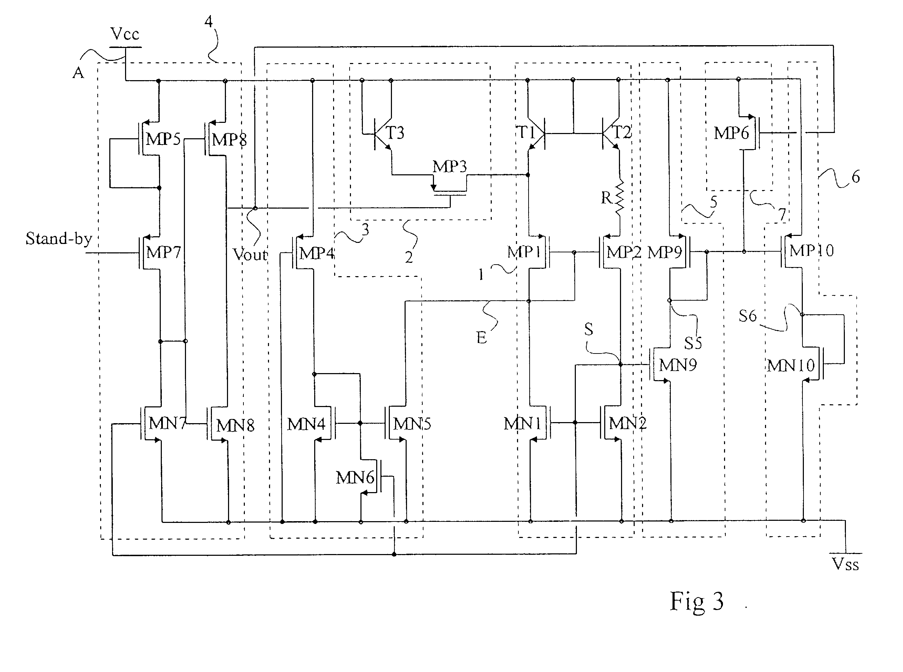

Une source de polarisation en ΔVbe/R comporte deux états stables. Un premier état, dit actif, correspond à un état dans lequel un courant circule dans chacune des branches T1, MP1, MN1 et T2, R, MP2, MN2 de la source de polarisation 1. Un second état, dit inactif, correspond à un état dans lequel aucun courant ne circule dans les branches T1, MP1, MN1 et T2, R, MP2, MN2 de la source de polarisation 1. Ce fonctionnement en mode bistable est lié aux tensions drain-source des transistors MOS MP1, MN1, MP2, MN2 qui bloquent la source de polarisation dans son état inactif. De fait, ces transistors sont bloqués tant que leur grille n'est pas portée à un potentiel, par rapport au potentiel de leur source, qui soit respectivement, inférieur pour un transistor à canal P, supérieur pour un transistor à canal N, d'une valeur correspondant à la tension seuil VT du transistor. De même, une fois qu'ils sont conducteurs, ils le resteront tant que le potentiel de leur grille n'atteindra pas ce potentiel. La source de polarisation 1 doit donc pouvoir être activée, ou démarrée, à la mise sous tension du circuit. Cette activation initiale est généralement effectuée au moyen d'un dispositif d'aide au démarrage 3 dont un mode de réalisation sera exposé par la suite, en relation avec la figure 3.

Lorsque la source de polarisation 1 est activée, le courant qui la traverse est proportionnel à la différence entre les tensions base-émetteur des transistors bipolaires T1, T2, et inversement proportionnel à la résistance de polarisation R. De fait, lorsque la source de polarisation 1 est active et équilibrée, c'est-à-dire lorsque les courants qui circulent dans chacune de ses branches T1, MP1, MN1 et T2, R, MP2, MN2 sont égaux, le courant Ib dans chacune des branches est égal à ΔVbe/R. ΔVbe représente la différence Vbel-Vbe2 entre les tensions base-émetteur des transistors T1, T2.

L'invention propose, pour mettre en veille partiellement cette source de polarisation 1, de réduire le courant Ib qui traverse ses branches, c'est-à-dire le rapport ΔVbe/R.

Une première solution consiste à augmenter la valeur de la résistance de polarisation R à l'apparition d'un signal de mise en veille. Une seconde solution consiste à diminuer la valeur de ΔVbe à l'apparition d'un signal de mise en veille. On préférera cette seconde solution car, comme on le verra par la suite, elle peut être mise en oeuvre au moyen de transistors, ce qui limite, dans un circuit intégré, la surface de puce nécessaire par rapport à l'emploi d'une résistance.

Le dispositif de mise en veille partielle 2, tel que représenté à la figure 1, sert à modifier, à l'apparition d'un signal de mise en veille, la différence entre les tensions base-émetteur Vbe des transistors bipolaires des branches de la source de polarisation 1.

Pour ce faire, le dispositif de mise en veille partielle 2 comprend un transistor bipolaire de type NPN T3 et un transistor MOS à canal P MP3. Le collecteur et la base du transistor T3 sont connectés à la borne A d'alimentation, tandis que son émetteur est relié à la source du transistor MP3. La grille de ce transistor MP3 reçoit un signal logique de commande de mise en veille "Stand-by" tandis que son drain est relié à l'émetteur du transistor bipolaire T1 de la source de polarisation 1. Le transistor T3 est donc monté en parallèle sur le transistor T1, la connexion en parallèle de ces deux transistors étant commandée par le transistor MP3. Ce transistor MP3 joue le rôle d'un interrupteur commandé par le signal de commande de mise en veille "Stand-by".

Ainsi, on utilise le fait que la tension base-émetteur Vbe d'un transistor bipolaire est proportionnelle à la surface d'émetteur S du transistor pour modifier virtuellement la tension base-émetteur du transistor équivalent d'une branche de la source de polarisation 1. En effet la tension base-émetteur d'un transistor bipolaire est, en première approximation, égale à kT/q * Ln(Ic/(S*Io)), où k représente la constante de Boltzmann, q la charge d'un électron, T la température de fonctionnement, Ic le courant de collecteur du transistor, Io le courant de saturation du transistor, et où S représente la surface d'émetteur du transistor. La valeur kT/q est constante pour une température de fonctionnement donnée. De la sorte, à une température donnée, la différence entre les tensions base-émetteur des transistors T1, T2 dépend du rapport entre leurs surfaces d'émetteur. En effet, le ΔVbe peut être exprimé sous la forme ΔVbe = Vbe1-Vbe2 = kT/q * Ln(S2/S1), où S1, S2 représentent respectivement les surfaces d'émetteur des transistors T1, T2.

La source de polarisation 1 peut donc être mise en veille partiellement au moyen du signal de commande de mise en veille "Stand-by". En l'absence d'un signal de mise en veille, le transistor MOS MP3 est bloqué et seul le transistor T1 participe à la production du courant de polarisation Ib. On suppose pour cela que le signal logique de commande de mise en veille "Stand-by" est dans un état haut en l'absence de mise en veille, et dans un état bas pour commander une mise en veille de la source de polarisation 1. En présence d'un signal de mise en veille, le transistor MOS MP3 conduit, ce qui provoque la mise en parallèle des transistors T1, T3. De la sorte, la première branche de la source de polarisation 1 présente un transistor bipolaire de surface équivalente à la somme des surfaces d'émetteur des transistors T1, T3. Ainsi le rapport des surfaces d'émetteur entre les deux branches de la source de polarisation 1 diminue, et par conséquent le courant Ib traversant la source de polarisation 1 diminue également.

Il est à noter que la valeur de ce courant de veille est paramétrable à la réalisation du circuit. De fait, on choisit la valeur du courant de veille Is devant circuler dans les branches de la source de polarisation 1 par la valeur de la surface de l'émetteur du transistor T3.

La figure 2 montre la relation entre la valeur du courant de veille Is dans la source de polarisation 1 en fonction de la surface d'émetteur du transistor T3. Pour l'établissement de cette figure, on a supposé que le transistor T1 présentait une surface d'émetteur unité, et que le transistor T2 présentait une surface d'émetteur de n unités. La valeur de la surface d'émetteur du transistor T3 correspond à p unités.

Comme on peut le constater, le courant devient nul lorsque la surface d'émetteur du transistor T3 atteint la valeur de n-1 unités. Cette valeur représente la valeur extrême qui correspond à rendre la somme des surfaces d'émetteur des transistors T1 et T3 égale à la surface d'émetteur du transistor T2. Dans ce cas, le ΔVbe devient nul et la source de polarisation 1 est coupée. Ce seuil est cependant difficile à atteindre en raison de contraintes technologiques de fabrication. De surcroît, cela poserait alors un problème de redémarrage de la source de polarisation 1, dans la mesure où, comme on l'a vu précédemment, les états actifs et inactifs d'une telle source en ΔVbe/R sont des états stables.

A titre d'exemple, on a réalisé un tel dispositif au moyen de transistors T1, T2, T3 avec des valeurs de surfaces d'émetteur respectivement de 1, 10, 8. Pour une tension d'alimentation Vcc de 2,7 V et une résistance de polarisation R de 60 kΩ, le ΔVbe nominal, à la température de fonctionnement du dispositif, est de 60 mV et le ΔVbe en veille est de 2,74 mV. Ainsi, le courant Ib présente une valeur nominale In de 1 µA et une valeur en veille Is de 0,045 µA.

Le mode de réalisation, décrit ci-dessus, consiste à augmenter virtuellement la surface d'émetteur du transistor équivalent de la première branche pendant les périodes de veille. On peut obtenir le même résultat en diminuant virtuellement la surface d'émetteur du transistor équivalent de la deuxième branche pendant les périodes de veille. Pour ce faire, on reproduit le dispositif de mise en veille partielle sur le transistor T2, et on inverse la commande de mise en veille. Ainsi, en l'absence de mise en veille, la surface virtuelle d'émetteur du transistor équivalent de la deuxième branche correspond à la somme de la surface d'émetteur du transistor T2 et de la surface d'émetteur du transistor en parallèle. L'apparition d'un signal de mise en veille provoque la suppression de la mise en parallèle du transistor associé au transistor T2, ce qui supprime la contribution de sa surface d'émetteur.

Il est également possible d'associer ces deux solutions pour disposer de plusieurs valeurs de courant pendant différentes périodes de mise en veille, sur la base de différents signaux de commande de mise en veille. Ainsi, l'énergie consommée d'une même source de polarisation 1 peut être fixée à plus de deux valeurs en fonction du fonctionnement souhaité pour le circuit dans lequel elle est implantée. Cela permet d'optimiser l'autonomie d'un tel circuit s'il est alimenté par une alimentation autonome. On peut encore multiplier le nombre des valeurs des courants de veilles partielles en plaçant en parallèle sur un des transistors T1, T2, plusieurs transistors bipolaires en parallèle. Chacun de ces transistors est alors commandé par un signal de commande de mise en veille qui lui est associé, au moyen d'un transistor MOS.

La figure 3 montre un circuit de commande de mise en veille partielle d'une source de polarisation 1 qui, pourvu d'un dispositif de mise en veille partielle 2 tel que représenté à la figure 1, permet de limiter la consommation d'énergie du circuit de commande.

Comme le montre cette figure, le circuit de commande de la source de polarisation 1, selon l'invention, comporte essentiellement trois dispositifs. Un dispositif de mise en veille partielle 2 de la source de polarisation 1 par réduction de son ΔVbe, un dispositif d'aide au démarrage 3 de la source de polarisation 1, et un dispositif logique 4 à charge active.

La source de polarisation 1 est alimentée entre deux bornes A, B aux potentiels Vcc, Vss d'une tension d'alimentation fournie par exemple par une batterie (non représentée). Un signal de commande de mise en veille "Stand-by" est reçu par le circuit de commande. Le signal "Stand-by" est envoyé au dispositif logique 4, chargé de provoquer une commutation franche du dispositif de mise en veille 2 sur l'apparition d'un changement d'état du signal "Stand-by".

La source de polarisation 1 est identique à celle représentée à la figure 1. Ses éléments ont été désignés par les mêmes références. Une sortie S de la source de polarisation 1 est envoyée, par l'intermédiaire d'un dispositif 5 (communément appelé "courroie de transmission"), sur un étage de sortie 6 qui constitue un étage de polarisation d'un module à polariser (non représenté).

Cette source de polarisation 1 dispose d'une entrée de commande E constituée par les drains des transistors MP1, MN1, qui sont reliés à une sortie du dispositif d'aide au démarrage 3.

Le dispositif d'aide au démarrage 3 comprend quatre transistors MOS MP4, MN4, MN5, MN6. La source du transistor MOS à canal P MP4 est connectée à la borne A, tandis que sa grille est connectée à la borne B de la tension d'alimentation. Le drain de ce transistor MP4 est relié au drain du transistor MOS à canal N MN4, monté en diode avec sa grille reliée à son drain. La source du transistor MN4 est connectée à la borne B. Les drains des transistors MP4, MN4 sont également reliés à la grille du transistor MOS à canal N MN5 dont la source est connectée à la borne B. En d'autres termes, ce transistor MN5 est monté en miroir avec le transistor MN4. Le drain du transistor MN5, qui constitue la sortie du dispositif d'aide au démarrage 3 est relié aux drains des transistors MP1, MN1, qui constituent l'entrée de commande E de la source de polarisation 1.

Les grilles des transistors MN4, MN5 sont également reliées au drain du transistor à canal N MN6. La source de ce transistor MN6 est connectée à la borne B et sa grille est reliée à la borne de sortie S de la source de polarisation 1. En d'autres termes ce transistor MN6 est monté en miroir avec les transistors MOS inférieurs MN1, MN2 de la source de polarisation 1.

Le rôle du dispositif d'aide au démarrage 3 est, lors de la mise sous tension du circuit, de s'assurer que la source de polarisation 1 passe de son état inactif vers son état actif.

De fait, à la mise sous tension du circuit, le transistor MP4 conduit dans la mesure où sa tension grille source est égale à Vcc-Vss. Le potentiel de la grille des transistors MN4, MN5 est donc au potentiel Vcc, diminué de la chute de tension dans la résistance série du transistor MP4. Comme les sources des deux transistors MN4, MN5 sont au potentiel Vss, ces transistors MN4, MN5 conduisent également. Le transistor MN5 polarise alors les grilles des transistors MP1, MP2 au potentiel Vss, à la chute de tension dans la résistance série du transistor MN5 près. Ainsi ces transistors MP1, MP2 entrent en conduction, et par la liaison entre les grilles des transistors MN1, MN2 avec le drain du transistor MP2, les transistors MN1, MN2 entrent également en conduction. La source de polarisation 1 se trouve alors dans son état stable actif.

Par contre, les courants qui circulent dans les transistors MN1, MN2 sont déséquilibrés en raison de la conduction du transistor MN5. Mais, lorsque la source de polarisation 1 a démarré, le transistor MN6 se met à conduire dans la mesure où il est monté en miroir sur les transistors MN1, MN2. Cela provoque le blocage de ce transistor MN5, qui ne tire alors plus de courant sur la source de polarisation 1, ce qui permet d'équilibrer les courants qui circulent dans ses branches. Le transistor MN6 joue le rôle d'un interrupteur commandé par la source de polarisation 1 pour désactiver le dispositif d'aide au démarrage, hors des périodes de mise sous tension du circuit.

Le dispositif d'aide au démarrage 3 ne sert qu'à la mise sous tension du circuit. Il n'est d'aucune utilité par la suite. De ce fait, on veillera à ce que la résistance série du transistor MP4 soit suffisamment élevée pour limiter la consommation en courant de ce dispositif. En d'autres termes le transistor MP4 présente un W/L important, c'est-à-dire une longueur de grille importante par rapport à sa largeur de grille.

Le dispositif logique 4 est constitué de deux inverseurs à base de transistors MOS. Un premier inverseur de ce dispositif logique 4 comprend trois transistors MOS MP5, MP7, MN7, le transistor MOS à canal N MN7 représentant une charge active commandée par la source de polarisation 1. Le transistor MP5 est monté en diode pour abaisser le seuil de déclenchement de cet inverseur à la valeur Vcc-2*Vgsp, où Vgsp représente la tension seuil grille-source des transistors MOS à canal P MP5, MP7. La source du transistor MOS à canal P MP5 est connectée à la borne A tandis que sa grille est reliée à son drain, lui-même relié à la source du transistor MOS à canal P MP7. La grille du transistor MP7 reçoit le signal de commande de mise en veille "Stand-by" tandis que son drain est relié au drain du transistor MN7. La source de ce transistor MN7 est connectée à la borne B alors que sa grille est reliée à la borne de sortie S de la source de polarisation 1. En d'autres termes ce transistor MN7 est monté en miroir avec les transistors inférieurs MN1, MN2 de la source de polarisation 1. Les drains des transistors MP7, MN7 constituent la sortie du premier inverseur du dispositif logique 4 qui est envoyée sur un second inverseur à base de transistors MOS.

Ce second inverseur est un inverseur CMOS classique. Il comprend deux transistors MOS MP8, MN8 dont les grilles sont reliées ensembles aux drains des transistors MP7, MN7. La source du transistor MOS à canal P MP8 est connectée à la borne A de la tension d'alimentation tandis que son drain est relié au drain du transistor à canal N MN8. La source du transistor MN8 est connectée à la borne B de la tension d'alimentation. Les drains des deux transistors MP8, MN8 constituent la sortie Vout de ce second inverseur et du dispositif logique 4.

Le rôle du dispositif logique 4 est double. D'une part, il accélère, par la géométrie des transistors qui le constituent, la commutation du dispositif de mise en veille. D'autre part, il transforme l'état bas du signal de commande de mise en veille "Stand-by", qui sert à la commutation du dispositif de mise en veille 2, en un signal logique du point de vue de ce dernier. En effet, bien que le signal de commande de mise en veille "Stand-by" soit lui-même un signal logique, il est fréquent que ses potentiels d'états ne correspondent pas aux potentiels Vcc et Vss de la tension d'alimentation de la source de polarisation 1, mais qu'ils représentent des potentiels intermédiaires V+ et V-.

Le rôle de la charge active du premier inverseur est de limiter la consommation du dispositif logique 4, hors des périodes de commutation de la source de polarisation 1 entre son état nominal de fonctionnement et son état de veille.

La sortie Vout du dispositif logique 4 constitue le signal de commande de mise en veille partielle de la source de polarisation 1. Cette sortie est donc reliée à la grille du transistor MOS à canal P MP3 du dispositif de mise en veille 2. Ce dispositif de mise en veille 2 est constitué, comme à la figure 1, d'un transistor bipolaire de type NPN T3 monté en parallèle sur le transistor T1 de la source de polarisation 1, par l'intermédiaire du transistor MP3.

La sortie Vout du dispositif logique 4 est également envoyée sur la commande d'un interrupteur 7 constitué d'un transistor MOS à canal P MP6. Le rôle de cet interrupteur 7 est de désactiver l'étage de sortie 6 de la source de polarisation 1 pendant les périodes de veille de cette dernière. Dans le mode de réalisation représenté, cet interrupteur 7 désactive l'étage de sortie 6 et ainsi le module (non représentés) qu'il est chargé de polariser.

Le dispositif 5 (communément appelé "courroie de transmission") est constitué de deux transistors MOS MP9, MN9. Le transistor MOS à canal P MP9 est connecté par sa source à la borne A de la tension d'alimentation. Son drain, qui constitue la sortie S5 de ce dispositif 5, est relié à sa propre grille et au drain du transistor à canal N MN9. La source de ce transistor MN9 est connectée à la borne B de la tension d'alimentation. La grille de ce transistor MN9, qui constitue l'entrée de ce dispositif 5, est reliée à la borne de sortie S de la source de polarisation 1. En d'autres termes, ce transistor MN9 est monté en miroir avec les transistors inférieurs MN1, MN2 de la source de polarisation 1.

L'étage de sortie 6 est constitué de deux transistors MOS MP10, MN10. Le transistor MOS à canal P MP10 est connecté par sa source à la borne A de la tension d'alimentation, tandis que son drain est relié au drain du transistor à canal N MN10, monté en diode. La source de ce transistor MN10 est connectée à la borne B de la tension d'alimentation alors que son drain, relié à sa propre grille, constitue la sortie S6 de cet étage 6. L'entrée de cet étage 6 est constituée par la grille du transistor MP10 qui est reliée à la grille du transistor MP9 du dispositif 5. En d'autres termes le transistor MP10 est monté en miroir sur le transistor MP9.

L'interrupteur 7, constitué du transistor MP6, a pour rôle de commander le miroir de courant entre les transistors MP9, MP10. Sa source est connectée à la borne A de la tension d'alimentation tandis que son drain est relié aux grilles des transistors MP9, MP10. La grille de ce transistor MP6 reçoit en guise de signal de commande le signal de sortie Vout du dispositif logique 4. Ainsi, lorsque le transistor MP6 conduit, les grilles des transistors MP9, MP10 sont au potentiel Vcc de la borne A, à la chute de tension dans la résistance série du transistor MP6 près. Par conséquent, les transistors MP9, MP10 sont bloqués et l'étage de sortie 6 est désactivé. Lorsque le transistor MP6 est bloqué, les deux transistors MP9, MP10 conduisent et l'étage de sortie 6 peut délivrer un courant au module dont il est chargé d'activer la polarisation.

D'autres étages de sorties, similaires à l'étage 6, peuvent aisément être associés à la source de polarisation 1. Pour ce faire, on peut par exemple reproduire, au moyen d'un transistor MOS à canal P et d'un transistor MOS à canal N par étage de sortie, le montage des transistors MP10, MN10. La grille du transistor à canal P de chaque étage est reliée à la grille du transistor MP9, de sorte que tous les étages de sortie fonctionnent de la même manière que l'étage 6. La sortie de chaque étage est constituée par les drains des transistors qui le constituent.

Le circuit de commande selon l'invention limite la consommation des dispositifs qui le constituent en dehors de leurs périodes de fonctionnement utile. Ce circuit permet notamment de limiter la consommation en courant du dispositif logique 4, pendant la veille de la source de polarisation 1, au moyen de la charge active MN7 commandée par la source de polarisation 1.

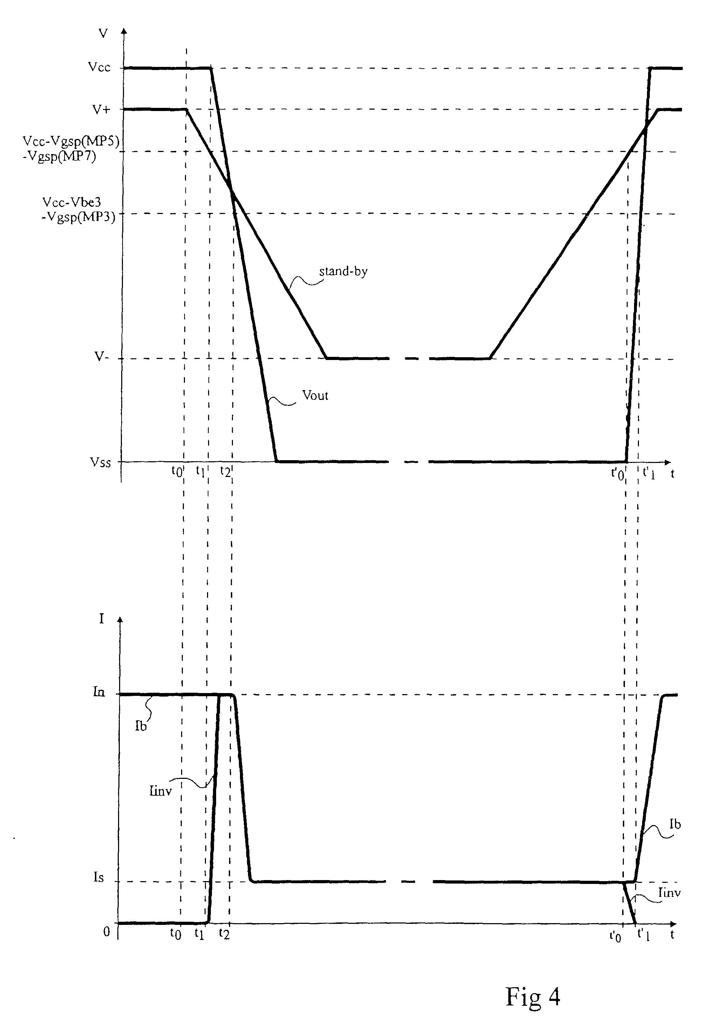

Ce fonctionnement est illustré par la figure 4 qui représente, sous forme de chronogrammes, le potentiel du signal "Stand-by" et de la sortie Vout du dispositif logique 4, et les courants Iinv, Ib circulant respectivement dans le transistor MN7 et dans la source de polarisation 1.

En l'absence de commande de mise en veille sur l'entrée du circuit de commande, on suppose que le signal "Stand-by" est dans un état haut correspondant au potentiel V+. La source de polarisation 1 se trouvant dans son état actif, les transistors MP1, MP2, MN1, MN2 conduisent.

Aucun courant ne circule dans le dispositif logique 4, dans la mesure où le signal de commande de mise en veille "Stand-by" est dans son état haut V+, le transistor MP7 est donc bloqué. On suppose pour cela que la valeur du potentiel V+ est supérieure à Vcc-Vgsp(MP5)-Vgsp(MP7) qui représente le seuil de déclenchement du transistor MP7, avec Vgsp(MP5) représentant la tension seuil grille-source du transistor MP5 et Vgsp(MP7) représentant la tension seuil grille-source du transistor MP7.

Si ce n'est pas le cas, il est nécessaire d'abaisser encore le seuil de déclenchement du transistor MP7 pour permettre le fonctionnement de la mise en veille. Un moyen pour abaisser le seuil de déclenchement du transistor MP7 consiste à ajouter un ou plusieurs transistors supplémentaires montés en diode entre la borne A et la source du transistor MP5.

A l'instant t0, le signal "Stand-by" entame une transition vers son état bas. Tant que le signal "Stand-by" n'a pas atteint la valeur Vcc-Vgsp(MP5)-Vgsp(MP7), la sortie Vout du dispositif logique 4 reste à la valeur Vcc, à la chute de tension dans la résistance série du transistor MP8 près. Le courant Ib dans la source de polarisation 1 est à sa valeur nominale In, fixée par la géométrie des transistors T1, T2. Comme l'inverseur à charge active n'a pas encore commuté, aucun courant Iinv ne circule dans le transistor MN7.

Dès l'instant t1, où le signal "Stand-by" atteint la valeur Vcc-Vgsp(MP5)-Vgsp(MP7), le transistor MP7 entre en conduction. Le courant Iinv dans le transistor MN7 présente alors un pic pour rejoindre le courant Ib sur lequel il est miroité.

Dès que le potentiel Vout à la sortie du dispositif logique 4 atteint la valeur Vcc-Vgsp(MP6), le transistor MP6 entre en conduction. Ainsi l'étage de sortie 6 de la source de polarisation 1 est désactivé. Cette désactivation de l'étage de sortie 6 se produit quasiment à l'instant t1, dans la mesure où la tension Vout présente une forte pente verticale. Dans le cas où plusieurs étages de sorties sont associés au dispositif de transmission 5 et à l'interrupteur 7, tous ces étages sont désactivés.

A l'instant t2, où le signal Vout atteint la valeur Vcc-Vbe3-Vgsp(MP3), le transistor MP3 entre en conduction et la mise en veille est déclenchée. Le courant Ib chute alors à la valeur Is fixée par la géométrie des transistors T1, T2, T3, et la source de polarisation 1 est en veille.

Comme le transistor MN7 qui constitue la charge active du dispositif logique 4 est monté en miroir sur les transistors MN1, MN2, le courant Iinv qui traverse ce transistor MN7 est limité à la valeur du courant de veille Is de la source de polarisation 1. On peut même chercher à réduire encore cette valeur en réduisant le rapport W/L du transistor MN7 par rapport au rapport W/L du transistor MN2.

Ainsi, la consommation en courant du dispositif logique 4 est réduite dès que la source de polarisation 1 est en veille. On limite la consommation d'énergie du dispositif logique 4 à une valeur prédéterminée, quelle que soit la durée de transition du signal de commande de mise en veille "Stand-by" entre ses deux états. Cela n'est pas le cas pour un inverseur classique, où le courant dans l'inverseur est lié au potentiel du signal "Stand-by". En effet, ce courant est fixé par le rapport du potentiel du signal "Stand-by" sur la résistance série des transistors MOS qui constituent l'inverseur.

En outre, cette consommation résiduelle est indépendante des potentiels des états du signal de commande de mise en veille "Stand-by". Ainsi le courant Iinv dans l'inverseur à charge active est limité à la même valeur, même si les potentiels V+, V-, des états hauts et bas du signal "Stand-by" diffèrent des potentiels des bornes A et B. Cela n'est pas le cas dans les dispositifs de l'art antérieur, où la consommation résiduelle pendant les périodes de veille de la source de polarisation est d'autant plus importante que la différence entre le potentiel V- et le potentiel Vss est importante.

Lorsque le signal de commande de mise en veille "Stand-by" entame une transition vers son état haut, indiquant une demande de retour au fonctionnement nominal de la source de polarisation 1, la commutation inverse s'effectue aux mêmes seuils de déclenchement que précédemment.

Ainsi, à l'instant t'0, où le potentiel du signal "Stand-by" atteint la valeur seuil Vcc-Vgsp(MP5)-Vgsp(MP7), les transistors MP5 et MP7 se bloquent. Cela provoque la remontée du signal Vout, sous l'effet du transistor MN7 et du deuxième inverseur constitué des transistors MP8 et MN8. Le courant Iinv devient nul. A l'instant t'1, où le signal Vout atteint la valeur Vcc-Vbe3-Vgsp(MP3), le transistor MP3 se bloque, et par conséquent le transistor T3 se bloque également. Le courant Ib de la source de polarisation 1 retrouve alors la valeur nominale In. La sortie Vout retrouve le potentiel Vcc, à la chute de tension dans la résistance série du transistor MP8 près.

Dès que le potentiel Vout de la sortie du dispositif logique 4 atteint la valeur Vcc-Vgsp(MP6), l'étage de sortie 6 de la source de polarisation 1 est de nouveau activé. Comme lors de la mise en veille, cette activation est immédiate.

La représentation de la figure 4 n'est pas à l'échelle pour des raisons de clarté. En particulier, la différence entre les valeurs des potentiels Vcc-Vgsp(MP5)-Vgsp(MP7) et Vcc-Vbe3-Vgsp(MP3) est en réalité très faible, voire inversée, par rapport à cette représentation. Comme le potentiel Vout de sortie du dispositif logique 4 prend la valeur Vcc, à la chute de tension dans la résistance série du transistor MP8 près, dès que le signal "Stand-by" atteint la valeur Vcc-2*Vgsp, la commutation des transistors MP3 et MP6 est dans ce cas simultanée.

Pour les besoins de la présente description, les tensions seuil grille-source des transistors MOS ont été désignées individuellement. En pratique, ces transistors étant réalisés à partir d'une même puce, des transistors de même type (canal N, canal P) présenteront approximativement la même tension seuil grille-source.

Bien que cela n'ait pas été représenté aux figures, on peut, au moyen de l'invention, réaliser une source de polarisation qui présente plusieurs valeurs différentes de courants de veille Is. Ceci, lorsque le système dans lequel est implantée cette source de polarisation peut présenter plusieurs modes de veille différents. On prévoit pour cela, autant de dispositifs de mise en veille 2 et de dispositifs logiques 4 que de modes de fonctionnement. On prévoit de plus de pouvoir commander, par les sorties des dispositifs logiques, les différents étages de sorties chargés d'activer la polarisation des différents modules du système.

Pour ce faire, on peut par exemple supprimer l'interrupteur 7, et avoir recours pour chaque étage de sortie associé au dispositif de transmission 5, à un second transistor MOS à canal N dont la source est reliée à la borne B, et dont le drain est relié au drain du premier transistor MOS à canal N de l'étage considéré. La grille de ce second transistor à canal N peut alors être commandée, par exemple, par l'inverse de la sortie du dispositif logique associé à cet étage, pour placer la sortie de l'étage au potentiel Vss, pendant les périodes de veille souhaitées pour l'étage considéré. Les seconds transistors MOS à canal N jouent alors le rôle d'interrupteurs commandés par le dispositif logique auquel ils sont associés.

On pourrait également prévoir plusieurs dispositifs de transmission 5, associés chacun à un interrupteur 7 commandé par un dispositif logique, et à un ou plusieurs étages de sortie 6.

Bien entendu, la présente invention est susceptible de diverses variantes et modifications qui apparaîtront à l'homme de l'art. En particulier, le choix des rapports entre les largeurs et les longueurs des grilles des transistors est fonction de l'utilisation à laquelle est destinée la source de polarisation. Dans le même ordre d'idée, chacun des composants décrits pourra être remplacé par un ou plusieurs éléments remplissant la même fonction.

## Revendications

1. Circuit de commande de mise en veille d'une source de polarisation (1) en ΔVbe/R à partir d'au moins un signal de commande de mise en veille ("Stand-by"), la source de polarisation étant pourvue de deux transistors bipolaires (T1, T2) montés en miroir, caractérisé en ce qu'il comporte au moins un dispositif de mise en veille partielle (2) muni de moyens pour modifier virtuellement, en fonction de l'état du signal de commande de mise en veille ("Stand-by"), la surface d'émetteur d'au moins un desdits transistors bipolaires (T1, T2), montés en miroirs, que comporte la source de polarisation (1), et au moins un dispositif logique (4) recevant le signal de commande de mise en veille ("Stand-by") et constitué d'au moins un premier inverseur à charge active commandée par la source de polarisation (1), une sortie (Vout) dudit dispositif logique (4) étant destinée à commander lesdits moyens d'augmentation virtuelle de la surface du transistor bipolaire (T1) de la source de polarisation (1).

2. Circuit de commande de mise en veille selon la revendication 1, caractérisé en ce qu'il comporte au moins un interrupteur (7) de commande d'au moins un étage de sortie (6) de la source de polarisation (1), ledit interrupteur (7) étant commandé par la sortie (Vout) du dispositif logique (4).

3. Circuit de commande de mise en veille selon la revendication 1 ou 2, caractérisé en ce que lesdits moyens pour modifier virtuellement la surface d'émetteur d'un des transistors bipolaires (T1, T2) de la source de polarisation (1) sont constitués d'au moins un transistor bipolaire (T3) monté, par l'intermédiaire d'un transistor MOS à canal N (MN3) commandé par la sortie (Vout) dudit dispositif logique (4), en parallèle avec ledit transistor bipolaire (T1) d'une branche de la source de polarisation (1) dont il doit modifier virtuellement la surface d'émetteur.

4. Circuit de commande de mise en veille selon la revendication 3, caractérisé en ce que la valeur du courant de veille (Is) circulant dans la source de polarisation (1) est paramétrée par le rapport des surfaces d'émetteur entre les deux transistors bipolaires (T1, T3) montés en parallèle et le transistor (T2) d'une autre branche de la source de polarisation (1).

5. Circuit de commande de mise en veille selon l'une quelconque des revendications 1 à 4, caractérisé en ce que ladite charge active dudit dispositif logique (4) est constituée d'un transistor MOS à canal N (MN7) monté en miroir avec des transistors MOS inférieurs à canal N (MN1, MN2) de la source de polarisation (1), ledit premier inverseur comportant au moins un transistor MOS à canal P (MP7) qui reçoit, sur sa grille, le signal de commande de mise en veille ("Stand-by"), son drain étant relié au drain du transistor à canal N (MN7) constituant la charge active et sa source étant connectée à une borne positive d'augmentation (A).

6. Circuit de commande de mise en veille selon la revendication 5, caractérisé en ce qu'au moins un transistor MOS à canal P (MP5), monté en diode, est intercalé entre la borne positive d'alimentation (A) et la source du transistor MOS à canal P (MP7) qui reçoit, sur sa grille, le signal de commande de mise en veille ("Stand-by").

7. Circuit de commande de mise en veille selon l'une quelconque des revendications 1 à 6, caractérisé en ce qu'il comporte en outre un dispositif d'aide au démarrage (3) dont une sortie est reliée à une entrée de commande (E) de la source de polarisation (1).

8. Circuit de commande de mise en veille selon la revendication 7, caractérisé en ce que le dispositif d'aide au démarrage (3) comporte un interrupteur (MN6) commandé par la source de polarisation (1) pour désactiver le dispositif d'aide au démarrage (3), hors des périodes de mise sous tension du circuit.

## Patentansprüche

1. Ein Bereitschaftssteuer-Schaltung für eine ΔVbe/R-Vorspannungsquelle (1) wenigstens eines Bereitschaftssteuersignals, aufweisend:
- zwei spiegelbildlich miteinander verbundene Bipolartransistoren (T1, T2),
- wenigstens eine Teilbereitschaftseinheit (2), welche Mittel für die virtuelle Veränderung der Emitteroberfläche von wenigstens einem der Bipolartransistoren (T1, T2) als Funktion des Zustandes des Bereitschaftssignals umfaßt, und
- wenigstens eine Logikeinheit (4), welche das Bereitschaftssteuersignal empfängt und welche wenigstens einen ersten aktiven Lastinverter aufweist, der durch die Vorspannungsquelle (1) gesteuert wird, wobei ein Ausgang (Vout) der Logikeinheit (4) die Mittel für die virtuelle Veränderung der Oberfläche des Bipolartransistors (T1) der Vorspannungsquelle steuert.

2. Schaltung nach Anspruch 1, dadurch **gekennzeichnet**, daß sie wenigstens einen Steuerschalter (7) für wenigstens eine Ausgangsstufe (6) der Vorspannungsquelle (1) aufweist, wobei der Schalter (7) mittels des Ausgangs (Vout) der Logikeinheit (4) gesteuert ist.

3. Schaltung nach Anspruch 1 oder 2, dadurch **gekennzeichnet**, daß die Mittel zur virtuellen Veränderung der Oberfläche eines der Bipolartransistoren (T1, T2) der Vorspannungsquelle (1) wenigstens einen Bipolartransistor (T3) umfassen, wobei der Bipolartransistor (T3) durch einen N-Kanal-MOS-Transistor (MN3), welcher durch den Ausgang (Vout) der Logikeinheit (4) gesteuert ist, parallel mit dem Bipolartransistor (T1) eines Zweiges der Vorspannungsquelle (1) verbunden ist, und wobei dessen Emitteroberfläche virtuell zu verändern ist.

4. Schaltung nach Anspruch 3, dadurch **gekennzeichnet**, daß der Wert des in der Vorspannungsquelle fließenden Bereitschaftsstromes (Is) dadurch angepaßt ist, daß das Verhältnis der Emitteroberflächen der beiden parallel verbundenen Bipolartransistoren (T1, T3) und eines Transistors (T2) eines anderen Zweiges der Vorspannungsquelle (1) auswählbar ist.

5. Schaltung nach einem der Ansprüche 1 bis 4, dadurch **gekennzeichnet**, daß die aktive Last der Logikeinheit (4) einen N-Kanal-MOS-Transistor (MN7) aufweist, welcher als ein Stromspiegel mit unteren N-Kanal-MOS-Transistoren (MN1, MN2) der Vorspannungsquelle (1) verbunden ist; daß der erste Inverter wenigstens einen P-Kanal-MOS-Transistor (MP7) aufweist, wobei an dessen Gate das Bereitschaftssteuersignal empfangen wird, wobei der Kollektor zum Kollektor des die aktive Last bildenden N-Kanal-Transistors (MN7) verbunden ist, und wobei die Source mit einem positiven Versorgungsterminal (A) verbunden ist.

6. Schaltung nach Anspruch 5, dadurch **gekennzeichnet**, daß zwischen dem positiven Versorgungsterminal (A) und der Source eines P-Kanal-MOS-Transistors (MP7) wenigstens ein mittels einer P-Kanal-Diode verbundener MOS-Transistor (MP5) angeordnet ist, wobei der P-Kanal-MOS-Transistor (MP7) an seiner Source das Bereitschaftssteuersignal empfängt.

7. Schaltung nach einem der Ansprüche 1 bis 6, weiterhin **gekennzeichnet** durch eine Starthilfeeinheit (3), welche einen mit einem Steuereingang (E) der Vorspannungsquelle (1) verbundenen Ausgang aufweist.

8. Schaltung nach Anspruch 7, dadurch **gekennzeichnet**, daß die Starthilfeeinheit (3) einen durch die Vorspannungsquelle (1) gesteuerten Schalter (MN6) aufweist, um die Starthilfeeinheit (3) außerhalb der Zeiträume einer Spannunganwendung auf die Schaltung zu deaktivieren.

## Claims

1. A stand-by control circuit for a ΔVbe/R bias source (1) from at least one stand-by control signal, the bias source comprising two mirror-connected bipolar transistors (T1, T2), includes at least one partial stand-by device (2) provided with means for virtually modifying, as a function of the state of the stand-by signal, the emitter surface area of at least one of said bipolar transistors (T1, T2), and at least one logic device (4) receiving the stand-by control signal and comprising at least one first active load inverter controlled by the bias source (1), one output (Vout) of said logic device (4) controlling said means for virtually modifying the surface area of said bipolar transistor (T1) of the bias source.

2. The circuit of claim 1, characterized in that it comprises at least one control switch (7) for at least one output stage (6) of the bias source (1), said switch (7) being controlled by the output (Vout) of the logic device (4).

3. The circuit of claim 1 or 2, characterized in that said means for virtually modifying the surface area of one of the bipolar transistors (T1, T2) of the bias source (1) include at least one bipolar transistor (T3) connected, through an n-channel MOS transistor (MN3) controlled by the output (Vout) of said logic device (4), in parallel with said bipolar transistor (T1) of one branch of the bias source (1), the emitter surface area of which must be virtually modified.

4. The circuit of claim 3, characterized in that the value of the stand-by current (Is) flowing in the bias source (1) is adjusted by selecting the emitter surface area ratio of the two bipolar transistors (T1, T3) connected in parallel and a transistor (T2) of another branch of the bias source (1).

5. The circuit of any of claims 1 to 4, characterized in that said active load of said logic device (4) comprises an n-channel MOS transistor (MN7) connected as a current mirror with lower n-channel MOS transistors (MN1, MN2) of the bias source (1); said first inverter comprising at least one p-channel MOS transistor (MP7) which receives, at the gate, the stand-by control signal, the drain being connected to a drain of said n-channel transistor (MN7) which constitutes the active load, and the source being connected to a positive supply terminal (A).

6. The circuit of claim 5, characterized in that at least one p-channel diode-connected MOS transistor (MP5) is interposed between the positive supply terminal (A) and the source of a p-channel MOS transistor (MP7) which receives the stand-by control signal at its gate.

7. The circuit of any of claims 1 to 6, characterized in that it further comprises a start-up aid device (3), having an output connected to a control input (E) of the bias source (1).

8. The circuit of claim 7, characterized in that said start-up aid device (3) includes a switch (MN6) controlled by the bias source (1) in order to deactivate the start-up aid device (3), outside the periods of application of a voltage to the circuit.
